# EUROPÄISCHE PATENTSCHRIFT

(11) **EP 2 054 166 B1**
(45) Veröffentlichungstag und Bekanntmachung des Hinweises auf die Patenterteilung: **14.06.2017**
(21) Anmeldenummer: 07802698.6
(22) Anmeldetag: 17.08.2007
(51) Int. Cl.: B05D 7/24, B05D 7/14

(54) **VERFAHREN UND VORRICHTUNG ZUM HERSTELLEN EINER BESCHICHTUNG**
METHOD AND DEVICE FOR PRODUCING A COATING
PROCÉDÉ ET DISPOSITIF POUR LA FABRICATION D'UN REVÊTEMENT

(30) Priorität: 18.08.2006 DE 102006038780
(43) Veröffentlichungstag der Anmeldung: 06.05.2009
(73) Patentinhaber: Fraunhofer-Gesellschaft zur Förderung der angewandten Forschung e.V., 80686 München (DE)
(72) Erfinder: IHDE, Jörg, 28865 Lilienthal (DE); DEGENHARDT, Jost, 28719 Bremen (DE); SALZ, Dirk, 28777 Bremen (DE); WÜBBEN, Thomas, 27721 Ritterhude (DE); LOMMATZSCH, Uwe, 28307 Bremen (DE)
(74) Vertreter: Eisenführ Speiser
(86) Internationale Anmeldenummer: PCT/EP2007/058594
(87) Internationale Veröffentlichungsnummer: WO 2008/020082

(56) Entgegenhaltungen:
- EP-A- 1 394 283
- WO-A-01/32949
- WO-A-99/20809
- DE-A1- 19 807 086
- DE-A1-102005 059 706

## Beschreibung

Die vorliegende Erfindung betrifft Vorrichtungen und Verfahren zum Herstellen von Korrosionsschutzschichten und entsprechende Schichten selbst.

Metalle neigen unter dem Einfluss von gasförmigen oder flüssigen Medium wie z. B. von Sauerstoff oder chloridhaltigem Wasser zur Korrosion. Die Korrosion ist in der Regel unerwünscht, da sie neben optischen Veränderungen unter anderem auch zu einer Verschlechterung der mechanischen Eigenschaften bis hin zur vollständigen Auflösung des Metalles führen kann.

Metallische Werkstoffe müssen daher üblicherweise vor Korrosion geschützt werden. Die Anforderungen an den jeweiligen Korrosionsschutz hängen dabei von dem jeweiligen Metall, dem Einsatzgebiet und der sich daraus ergebenden korrosiven Belastung ab. Korrosionsgeschützte metallische Werkstoffe sind in nahezu allen technischen Anwendungsbereichen zu finden. Im Sinne der vorliegenden Erfindung schließt der Begriff Metall auch metallische Legierungen ein. Metalle im Sinne der Erfindung sind insbesondere Eisen, Aluminium, Kupfer, Magnesium, Titan und deren Legierungen, insbesondere Stähle. In Metalllegierungen, die mit einem erfindungsgemäßen Verfahren bzw. einer erfindungsgemäßen Vorrichtung mit einem erfindungsgemäßen Korrosionsschutzschicht versehen werden können, können als Legierungsbestandteile insbesondere auch Magnesium, Silizium, Mangan, Kobalt, Zink und Kupfer enthalten sein.

Übliche Korrosionsschutzsysteme für Metalle und metallische Werkstoffe basieren auf badgestützten, nasschemischen Prozessen, bei denen im Anschluss an eine nasschemische Vorreinigung eine Beschichtung oder ein Überzug auf das Metall aufgebracht wird. Diese Korrosionsschutzschichten werden verstärkt als Chrom-VI-freie Beschichtungen angeboten, erfüllen jedoch oft nicht die Korrosionsschutzwirkungen von Chrom-VI-haltigen Korrosionsschutzschichten.

Nachteilig an badgestützten Korrosionsschutzschicht-Herstellungsverfahren sind zum einen der erforderliche Platzbedarf, zum anderen aber auch die Kosten für die Chemikalien und die Überwachung der Verfahrensdurchführung und Prozess-Sicherheit. Ebenfalls nachteilig ist der hohe Aufwand für die Abfall- und Abwasserbehandlung bzw. -entsorgung. Ebenfalls nachteilig ist, dass verschiedene Metalle einschließlich Metalllegierungen oft unterschiedliche Bäder und Badreihenfolgen zum Herstellen einer Korrosionsschutzschicht benötigen, die zum Teil miteinander inkompatibel sind. Metallische Werkstücke, die verschiedene Metalle enthalten, müssen dementsprechend häufig vor dem Zusammenbau separat behandelt werden.

Aus der DE 19807086 A1 ist ein Verfahren und eine Vorrichtung zum Herstellen von Korrosionsschutzschichten bekannt. Dabei wird ein Plasmastrahl erzeugt, wobei in eine plasmaaktivierte erste Gasphase eine zweite Gasphase eingebracht wird, die einen oder mehrere polymerisierbare Precursoren und/oder ein Aerosol und/oder einen pulverförmigen Feststoff enthält. Die Bestandteile der zweiten Gasphase sollen während ihres Fluges zu einer zu beschichtenden Oberfläche in zur Schichtabscheidung geeignete Teilchen-Spezies umgewandelt werden, um auf der zu beschichtenden Oberfläche eine Schicht zu bilden. Nachteilig an diesem Verfahren ist, dass die mit diesem Verfahren erreichbare Schichtabscheidungsrate von 0,4 µm/Sek. (Fläche von etwa 2 cm²) als zu gering empfunden wird. Zudem ist es schwierig, mit dem beschriebenen Verfahren eine gleichmäßige und wohl definierte Durchmischung der beiden Gasphasen zu erzeugen, um eine steuerbare Zusammensetzung bei gleichbleibender hoher Qualität der abgeschiedenen Korrosionsschutzschicht zu erzielen. Das Mischungsverhalten der beiden Gasphasen kann bei dem vorgeschlagenen Aufbau aufgrund der Strömungsgeschwindigkeit des zum Herstellen des Plasmas als erster Gasphase verwendeten Gases sowie dem genauen Abstand zwischen dem Bildungsort der ersten Gasphase und dem Einspeisungsort der vernetzbaren Monomere der zweiten Gasphase nur in einem unzureichenden Maße für definierte und kontrollierbare Entladungsbedingungen verwendet werden.

Es war deshalb eine Aufgabe der vorliegenden Erfindung, eine Vorrichtung und ein entsprechendes Verfahren zum Herstellen von Korrosionsschutzschichten anzugeben. Vorrichtung und Verfahren sollten es ermöglichen, Korrosionsschutzschichten mit gleichbleibend hoher Qualität herzustellen. Die Vorrichtung sollte möglichst einfach aufgebaut und zu warten sein. Das Verfahren sollte ebenfalls möglichst einfach sein und insbesondere für eine Vielzahl verschiedener Materialoberflächen und insbesondere verschiedener Metalle und Metalllegierungen brauchbare Korrosionsschutzschichten ohne Änderung der Zusammensetzung der zum Herstellen der Korrosionsschutzschichten verwendeten Ausgangsmaterialien ermöglichen. Ebenfalls sollten Korrosionsschutzschichten angegeben werden, die eine gleichbleibend gute Korrosionsschutzwirkung unterschiedlichster Metall-, Legierungs- und anderer Werkstückoberflächen ermöglichen. Die Korrosionsschutzschichten sollten mit hoher Geschwindigkeit und hohen Abscheideraten aufgebracht werden können.

Die Aufgabe wird gelöst durch eine Nichtvakuum - Beschichtungsvorrichtung, wie in Anspruch 1 definiert.

Überraschenderweise hat sich nunmehr herausgestellt, dass unter den in dieser erfindungsgemäßen Vorrichtung herrschenden Bedingungen besonders haltbare Korrosionsschutzschichten auf einer Vielzahl von Oberflächen und Metallen einschließlich Metalllegierungen aufgebracht werden können. Die so aufgebrachten Korrosionsschutzschichten sind besonders beständig und besonders gut haftend mit den verschiedensten Untergründen verbunden. Die Korrosionsschutzschichten können mit der erfindungsgemäßen Beschichtungsvorrichtung sowohl selektiv auf einzelne Punkte als auch großflächig aufgebracht werden. Eine Maskierung von nicht zu schützenden Flächen kann daher entfallen, kann aber ebenso gut auch vorgenommen werden. Mit der erfindungsgemäßen Vorrichtung ist es zudem auf vorteilhafte Weise möglich, die Nachteile von badbasierten Verfahren zum Aufbringen von Korrosionsschutzschichten zu vermeiden. Die erfindungsgemäße Beschichtungsvorrichtung ist eingerichtet, ein Substrat nicht im Vakuum, sondern bei Niederdruck oder Atmosphärendruck ab zumindest 100 mbar zu beschichten. Sie vermeidet daher die Nachteile von Unterdruckprozessen, die durch einen hohen apparativen Aufwand - beispielsweise für eine Vakuumkammer - gekennzeichnet sind. Überraschenderweise hat sich gezeigt, dass mit der erfindungsgemäßen Beschichtungsvorrichtung, insbesondere dank des Relaxationsraumes, selbst bei Atmosphärendruck Korrosionsschutzschichten auf einfache und zuverlässige Weise hergestellt werden können, die höchsten Ansprüchen an Korrosionsschutzwirkung genügen.

Eine zur erfindungsgemäßen Vorrichtung ähnliche Vorrichtung ist aus der EP 1230414 B1 bekannt. Darin ist eine Vorrichtung zur Plasmabeschichtung von Oberflächen beschrieben mit einem rohrförmigen, elektrisch leitfähigen, einen Düsenkanal bildenden Gehäuse, mit einer koaxial im Düsenkanal angeordneten Elektrode und mit einer Zufuhreinrichtung zur Zufuhr eines Precursormaterials in den Plasmastrahl, wobei ein Hochfrequenzgenerator zum Anlegen einer Wechselspannung zwischen der Elektrode und dem Gehäuse zum Erzeugen einer Bodenentladung vorgesehen ist. Mit der dort beschriebenen Vorrichtung können plasmapolymere Beschichtungen auf verschiedenen Oberflächen angeordnet werden. Die genannte Patentschrift zeigt jedoch weder einen Volumenstrom des zu ionisierenden Gases von 15 bis 50 l/min noch einen Abstand zwischen der Precursoreinspeisung und dem Austritt des Gehäuses des Plasmaerzeugungsraumes von 1 bis 25 mm, vorzugsweise von 1 bis 7 mm. Das Einhalten und apparative Sicherstellen dieser beider Rahmenbedingungen ist jedoch für das Erzeugen erfindungsgemäßer Korrosionsschutzschichten erforderlich.

Bei der Plasmapolymerisation wird ein strömendes Arbeitsgas, bevorzugt Druckluft, Sauerstoff oder Stickstoff durch Energiezufuhr zu einem Plasmastrahl angeregt. Das Arbeitsgas ist bei der Plasmapolymerisation ein Ionisationsgas, das heißt, ein Gas, das durch Energiezufuhr unter Bildung von Ionen, Elektronen und Photonen sowie reaktiven Spezies, wie z.B. reaktive Radikale, zu einem Plasmastrahl angeregt wird. Dem relaxierenden Plasmastrahl wird ein (ggf. zusätzliches) Precursormaterial zugeführt, das durch die aktiven Spezies im Plasmastrahl, insbesondere durch die Ionen, Radikale und Elektronen und durch die hohe Temperatur des Plasmastrahls fragmentiert. Der Plasmastrahl mit den Precursorfragmenten wird auf eine zu beschichtende Substratoberfläche geführt, auf der sich die reaktiven Fragmente des Precursormaterial zu einer Polymerschicht vernetzen. Plasmapolymerisation unterscheidet sich von einer Polymerisation im konventionellen Sinne insbesondere dadurch, dass das Ausgangsmaterial (Precursormaterial) zunächst fragmentiert/ionisiert/angeregt und anschließend polymerisiert wird. Das "Plasmapolymer eines Precursormaterials" ist das entsprechende Polymerisationsprodukt.

Das erfindungsgemäße Verfahren wird bei Atmosphärendruck ab 100 mbar durchgeführt, vorzugsweise 500 mbar bis 1500 mbar, besonders bevorzugt 700 mbar bis 1200mbar. Es wird daher keine Vakuumkammer benötigt, was die Herstellung von Korrosionsschutzschichten stark vereinfacht und damit Kosten einspart. Des Weiteren wird das erfindungsgemäße Verfahren vorzugsweise bei zeitlich konstanten Polymerisationsbedingungen durchgeführt, das heißt, während der Herstellung der Korrosionsschutzschichten müssen beispielsweise die Durchflussrate des Arbeitsgases, der Druck oder die zugeführte Energiemenge nicht variiert werden, wodurch die Verfahrensdurchführung und der benötigte apparative Aufwand weiter erleichtert werden.

Mit der erfindungsgemäßen Beschichtungsvorrichtung bzw. dem erfindungsgemäßen Beschichtungsverfahren wird erreicht, einen Plasmastrahl so zu modifizieren, dass es zu einer kontrollierten Relaxation des Plasmastrahles im wesentlichen ohne beeinträchtigende Wechselwirkung durch die umgebende Atmosphäre kommt. So kann es je nach verwendetem Ionisationsgas zwar zu einer Wechselwirkung zwischen den Precursor und dem Ionisationsgas kommen, oder auch zu einer Relaxation durch Wandstöße, die übrige Atmosphäre beeinflusst jedoch faktisch nicht die Relaxation des Plasmastrahles. Insbesondere würde bei Verwendung von Sauerstoff in einem oder als ein Ionisationsgas durch eine Wechselwirkung mit der umgebenden stickstoffhaltigen (Niederdruck-) Atmosphäre Stickoxid-Verbindungen NₓO_{y} gebildet, die zu einer unkontrollierten Gasphaseninteraktion führen würden. Entsprechend umgekehrt würde die Verwendung von Stickstoff als Ionisationsgas durch Wechselwirkung mit der umgebenden Atmosphäre ebenfalls zur Bildung unerwünschter Stickoxide führen. Beides kann durch das Vorsehen des Relaxationsraumes verhindert werden. Die Relaxation des Plasmas im Relaxationsraum wiederum ermöglicht es, die gewünschte Spezies- und Energieverteilung am Ort der Precursoreinspeisung (Monomereinspeisung) einzustellen. Durch Auswahl der Plasmaerzeugungsparameter bei einer gewöhnlichen Niederdruck- oder Atmosphärendruck-Plasmapolymerisationsvorrichtung ließe sich diese gewünschte Spezies- und Energieverteilung nicht einstellen, da das Plasma aufgrund der Wechselwirkungen mit der Atmosphäre kaum handhabbar beeinflusst würde.

Der Relaxationsraum ermöglicht daher eine ansonsten nicht zugängliche genaue Einstellung der Spezies- und Energieverteilung am Ort der Precursoreinspeisung und erlaubt so, den Grad der Precursorfragmentierung (Monomerfragmentierung) einzustellen, ohne dabei schwer handhabbare Atmosphäreneffekte berücksichtigen zu müssen. Dadurch ist es erstmals im Bereich der Niederdruck- und Atmosphärendruck-Plasmapolymerisation möglich, eine Partikelbildung in der Gasphase, die ansonsten ungewollt bei Verwendung hochfragmentierter Precursoren auftritt, deutlich und sicher zu reduzieren. Dies wiederum ermöglicht es, die Zahl an Beschichtungsfehlstellen pro Fläche bei ansonsten identischen Prozessparametern derart zu verringern, dass entsprechend hergestellte Beschichtungen als Korrosionsschutzschichten genutzt werden können.

Bevorzugt werden bei der Plasmapolymerisation ein Silizium-haltiges und oder Kohlenstoff-haltiges Precursormaterial eingesetzt, dem zum Beispiel Druckluft, Stickstoff oder Sauerstoff als Trägermedium und Reaktionspartner beigemengt werden können. Dabei wird die Menge und Zusammensetzung bei siliziumhaltigen Precursoren so gewählt, dass das Verhältnis von Si-Atomen zu O-Atomen in der Korrosionsschutzschicht im Bereich von 0,2 bis 1,1 liegt. Weiter bevorzugt wird die Menge an zusätzlich eingesetztem Sauerstoff so gewählt, dass das Verhältnis von Si-Atomen zu O-Atomen in der Korrosionsschutzschicht im Bereich von 0,3 bis 0,9 liegt. Weiter bevorzugt wird die Menge an zusätzlich eingesetztem Sauerstoff so gewählt, dass dieses Verhältnis im Bereich von 0,4 bis 0,6 liegt.

Da die Vernetzung der Molekülfragmente bevorzugt über Sauerstoffverbindungen stattfindet, führt der Einsatz von Sauerstoff als Arbeitsgas, Trägergas oder als Beimengung zum Arbeits- oder Trägergas während der Plasmapolymerisation zu einer stärkeren Vernetzung des sich bildenden bzw. gebildeten Siloxan-Netzwerkes, wodurch die Haft- und Barriereeigenschaften der Korrosionsschutzschicht weiter verbessert werden. Gleichzeitig kann aber der Einsatz von Sauerstoff als weiteres Precursormaterial nachteiligerweise, insbesondere bei zu hohen eingesetzten Konzentrationen, zu einer zu hohen Schichtspannung und dadurch zu Rissen in der Schicht führen. Weiterhin führt beispielsweise bei der Verwendung von Hexamethyldisiloxan (HMDSO) als Si-haltiges Precursormaterial der Einsatz einer zu großen Menge an Sauerstoff in Verbindung mit einer hohen Leistungsdichte zu einer hohen Partikelbildung in der Gasphase, wodurch die Korrosionsschutzeigenschaften der Korrosionsschutzschicht verschlechtert werden. Es ist daher wichtig, die Menge an Sauerstoff und die verwendete Leistungsdichte in der Entladung, bzw. am Ort der Einspeisung so zu wählen, dass sowohl eine gute Schichthaftung auf dem Substrat, als auch eine hohe Barrierewirkung der Schicht erreicht werden. Dies konnte erfindungsgemäß erreicht werden, indem die Menge an verwendetem Sauerstoff und die zur Precursorumwandlung zur Verfügung stehende Energiedichte so gewählt wurde, dass das Verhältnis von Si-Atomen zu O-Atomen in der gebildeten Korrosionsschutzschicht im Bereich von 0,2 bis 1,1 liegt.

Bevorzugt wird das sich bildende und/oder gebildete Plasmapolymer zudem so behandelt, dass reaktive Gruppen im Inneren der Korrosionsschutzschicht abgebaut werden.

Mit Hilfe der erfindungsgemäßen Vorrichtung können nun erstmals verschiedene Metalle, ihre Legierungen und insbesondere die in Badverfahren oft nur bedingt zu behandelnden Fügezonen zwischen metallischen Bauteilen beispielsweise Schweißnähte sicher mit einer dauerhaften und belastbaren Korrosionsschutzschicht versehen werden. Die Korrosionsschutzschicht kann eine Dicke von zumindest 5 nm besitzen und hat vorzugsweise eine Dicke bis 20 µm, besonders bevorzugt von 10 nm bis 10 µm und besonders bevorzugt von 50 nm bis 2 µm. Die Korrosionsschutzwirkung von mit der erfindungsgemäßen Beschichtungsvorrichtung erzeugten Korrosionsschutzschichten konnte gegenüber herkömmlichen plasmapolymeren Beschichtungen verbessert werden. Dabei scheint es eine ausschlaggebende Rolle zu spielen, dass die Precursoreinspeisung nicht innerhalb des Gehäuses erfolgt, in dem das Plasma erzeugt wird, sondern an einem Ort, an dem das Plasma bereits teilweise relaxiert ist. Unter den Bedingungen, die im Relaxationsraum der erfindungsgemäßen Vorrichtung im Betrieb herrschen, werden die Monomere des Precursors in dem reaktiven Gasstrom teilweise fragmentiert und mit dem Gasstrom auf die zu beschichtende Oberfläche geblasen. Dort scheidet sich dann eine plasmapolymere Schicht in Abhängigkeit der sich ergebenden Haftwahrscheinlichkeiten der erzeugten reaktiven Monomer-Fragmenten und Teilpolymerisate ab. Eine solche Umwandlung der Precursor-Monomere erfolgt jedoch nicht im geeigneten Maße im Bereich des aktiven Plasmas, also im Gehäuse des Plasmaerzeugungsraumes. Aufgrund der dort vorliegenden hohen Energiedichten und der sich daraus ergebenden Fragmente des Precursor kann es zu reaktiven Spezies mit einer geringeren Haftwahrscheinlichkeit an einer Oberfläche und zur Bildung von Partikeln in der Gasphase aufgrund von Stoßprozessen reaktiver Spezies kommen. Dadurch würde die Qualität einer erzeugten Korrosionsschutzschicht verringert. Durch die erfindungsgemäße Abstimmung zwischen dem Ort der Precursoreinspeisung und dem Volumenstrom des zu ionisierenden Gases werden unerwünschte Nebenreaktionen überraschenderweise auf ein Minimum reduziert, so dass die erfindungsgemäß besonders bevorzugten Korrosionsschutzschichten erzeugt werden können.

In bevorzugten Beschichtungsvorrichtungen ist die Precursoreinspeisung 0,25 bis 15 mm, vorzugsweise 1 bis 8 mm und besonders bevorzugt 2 bis 5 mm, von einer vertikalen Mittelachse des Relaxationsraumes entfernt angeordnet. Der Relaxationsraum ist dabei vorzugsweise rotationssymmetrisch ausgebildet.

Das zu ionisierende Gas ist vorzugsweise sauerstoffhaltig, insbesondere kann als zu ionisierendes Gas reiner Sauerstoff (gegebenenfalls in technischer Qualität) oder Luft, beispielsweise in Form von Druckluft, oder Stickstoff oder inerte Gase, denen man Sauerstoff beimengt, verwendet werden. Als Precursor-Trägergas wird vorzugsweise unter den Bedingungen eines zumindest teilweise relaxierten Plasmas, insbesondere Druckluft, Sauerstoff, Stickstoff oder inerte Gase wie Helium, Neon, Argon verwendet.

Der Precursor wird vorzugsweise in einem Trägergas, vorzugsweise Stickstoff, mit einem Trägergasstrom von 0,1 bis 20 l/min, besonders bevorzugt 0,8 bis 8 l/min und besonders bevorzugt 1 bis 4 l/min zugegeben. Besonders gute Ergebnisse können erzielt werden, wenn der Volumenstrom des zu ionisierenden Gases 15 bis 50 l/min, vorzugsweise 20 bis 40 l/min und besonders bevorzugt 25 bis 35 l/min und der Precursor-Trägergasstrom 1 bis 4 l/min und vorzugsweise 2 l/min beträgt. Mit den erfindungsgemäß gewählten Volumenströmen an zu ionisierendem Gas und Trägergas kann eine unerwünschte Pulverbildung auf vorteilhafte Weise vermieden werden, so dass die Qualität der mit der erfindungsgemäßen Vorrichtung abgeschiedenen Korrosionsschutzschichten besonders gut gefördert werden kann.

Bei hohen Flüssen an zu ionisierendem Gas kann ein Entladungsfilament aus dem Gehäuse des Plasmaerzeugungsraumes in den Relaxationsraum und aus der Beschichtungsvorrichtung bis zu der zu beschichtenden Oberfläche austreten. Dabei kann zum einen die zu beschichtende oder bereits beschichtete Oberfläche beschädigt werden, zum anderen findet bei Austritt eines Entladungsfilamentes in den Relaxationsraum auch im Relaxationsraum noch eine nennenswerte Plasmaaktivierung statt, so dass die mit der erfindungsgemäßen Vorrichtung besonders vorteilhaft eingestellten Bedingungen der Precursoreinspeisung nicht mehr vorlägen.

Eine erfindungsgemäße Vorrichtung besitzt jedoch wie oben beschrieben das Zuführungsmittel, nämlich eine Ionisationsgaszufuhr und vorzugsweise auch eine Trägergaszufuhr, mit denen die jeweiligen Volumenströme auf die erfindungsgemäß zuträglichen Werte eingestellt werden können.

Die erfindungsgemäße Beschichtungsvorrichtung umfasst vorzugsweise ferner einen Abstandhalter zum Halten eines zu beschichtenden Substrates auf einen Abstand von 0,5 bis 30 mm, besonders bevorzugt 1 bis 15 mm und noch stärker bevorzugt 3 bis 10 mm, gerechnet von einem Austritt aus dem Relaxationsraum. Es hat sich gezeigt, dass bei diesen Abständen die Precursor-Monomere eine vorteilhaft lange Zeit im relaxierenden Plasma befindlich sind, bis sie die zu beschichtende Oberfläche des zu beschichtenden Substrates erreichen. Durch die erfindungsgemäße Wahl des Abstandes zwischen dem Auslass des Relaxationsraumes und der zu beschichtenden Oberfläche des zu beschichtenden Substrates wird zudem auf vorteilhaft einfache Weise die Staub- und Pulverbildung weiter unterdrückt, so dass die Qualität der mit der erfindungsgemäßen Vorrichtung erzeugbaren Korrosionsschutzschichten besonders nachhaltig verbessert werden kann.

Die erfindungsgemäße Beschichtungsvorrichtung besitzt vorzugsweise zudem eine Temperierung zum Temperieren der zu beschichtenden Substratoberfläche auf eine Temperatur von 0 bis 300 C°, vorzugsweise von 20 bis 200 C° und besonders bevorzugt von 30 bis 100 C°. Eine Temperierung der zu beschichtenden Oberfläche auf den erfindungsgemäßen Temperaturbereich und insbesondere auf den bevorzugten oder besonders bevorzugten Temperaturbereich führt zu einer besonderen Steigerung der Korrosionsschutzwirkung von mit der erfindungsgemäßen Vorrichtung abgeschiedenen Korrosionsschutzschichten gegenüber Schutzschichten, die auf untemperierte Substratoberflächen abgeschieden werden. Es hat sich gezeigt, dass die Temperierung der Substratoberfläche nicht nur auf die Schichtvernetzung, sondern auch auf die Abscheiderate einen Einfluss ausüben. Die Temperung durch Temperieren wie vorstehend beschrieben ist deshalb besonders bevorzugt.

Die Temperung der Substratoberfläche kann vor, während oder nach dem Beaufschlagen mit einem precursorhaltigen relaxierenden Plasma erfolgen. Besonders bevorzugt ist es, wenn die Substrattemperung während oder besonders nach dem Beschichten der Substratoberfläche erfolgt. Auf diese Weise kann unter anderem die Medienbeständigkeit der Schicht gesteigert werden. Die erfindungsgemäß bevorzugte Temperung der Substratoberfläche kann auch durch die Verwendung von Plasmadüsen zur Vor- bzw. Nachbehandlung erfolgen, die im Betrieb direkt vor oder hinter dem Austritt der eingesetzten Beschichtungsdüse über eine zu beschichtende Substratoberfläche geführt werden und die zu beschichtende Oberfläche mit dem heißen, aus der zur Vor- oder Nachbehandlung eingesetzten Plasmadüse austretendem Gas zum Heizen der Oberfläche auf die gewünschte Temperatur beaufschlagen. Alternativ dazu kann entsprechend auch das Substrat unter den Düsen bewegt werden. Besonders bevorzugt ist dabei eine Anordnung, bei der die zu beschichtende Oberfläche nach der Behandlung mit dem precusorhaltigen relaxierenden Plasma temperiert wird.

Die Temperung wird vorzugsweise durchgeführt, indem die abgeschiedene Schicht, vorzugsweise eine Korrosionsschutzschicht, auf eine Temperatur zwischen 60 C° bis 300 C° unter Luft getempert wird. Die Zeitdauer des Tempervorganges beträgt bevorzugt mindestens eine Sekunde, weiter bevorzugt mindestens 10 Minuten und weiter bevorzugt mindestens 60 Minuten. Weiter bevorzugt wird die abgeschiedene Schicht nach der Abscheidung bei Atmosphärendruck bei einer Temperatur von 150 C° über mindestens 2 Stunden getempert. Alternativ oder zusätzlich kann die Substratoberfläche auch während der Polymerisation aufgeheizt werden, um eine thermische Behandlung auch schon während der Polymerisation zu bewirken, wobei während der Polymerisation die Temperatur bevorzugt maximal 100 C° beträgt und weiter bevorzugt zwischen 20 und 60 C° liegt. Die Korrosionsschutzeigenschaften der mit der erfindungsgemäßen Vorrichtung abscheidbaren Korrosionsschutzschicht werden dadurch verbessert, dass reaktive Gruppen, die sich in der abgeschiedenen Schicht befinden abgebaut werden. Wenn als Si-haltiges Precursormaterial beispielsweise HMDSO verwendet wird, verbleiben Silanol-Gruppen als reaktive Gruppen in der Schicht. Die thermische Behandlung führt dazu, dass die Silanol-Gruppen untereinander reagieren, insbesondere kondensieren, wodurch sie abgebaut werden und somit die Sperrwirkung und Stabilität der Schicht gegenüber korrosiven Medien erhöht wird.

Die erfindungsgemäße Beschichtungsvorrichtung umfasst vorzugsweise zudem eine Steuerung zum Führen des Austritts des Relaxationsraumes relativ zur zu beschichtenden Substratoberfläche dergestalt, dass mehrere einander teilweise überlappende Beschichtungen auf der Substratoberfläche gebildet werden. Üblicherweise wird die Substratoberfläche relativ zum Austritt des Relaxationsraumes mit einer Geschwindigkeit von 1 bis 100 m/min bewegt, insbesondere bevorzugt mit einer Geschwindigkeit von 5 bis 50 m/min und besonders bevorzugt von 20 m/min. Bei diesen Verfahrgeschwindigkeiten wird eine zu hohe Substraterwärmung vermieden und dennoch die Bildung besonders korrosionsschützender Schichten mit hoher Geschwindigkeit und hoher Qualität ermöglicht. Die Erreichbarkeit dieser Beschichtungsgeschwindigkeiten für qualitativ hohe Korrosionsschutzschichten ist ein besonderer Vorteil der Erfindung. So lassen sich beispielweise bei einer Verfahrgeschwindigkeit von 20m/min und der Verwendung von HMDSO als Precusormaterial Abscheideraten realisieren, die umgerecht auf die beschichtete Fläche mindestens doppelt so hoch sind, wie bei dem in DE 19897086 A1 beschriebenen Beispiel.

Die Schichtabscheidung mit der erfindungsgemäßen Einzeldüsen-Beschichtungsvorrichtung erzeugt üblicherweise eine lorentzförmige Schichtdickenverteilung mit einem Maximum unterhalb der Austrittsöffnung des Relaxationsraumes. Je nach Abstand von der Austrittsöffnung des Relaxationsraumes kann eine Schicht mit einer Breite von bis zu 80 mm erzeugt werden. In bevorzugten Ausführungsformen der Beschichtungsvorrichtung werden der Volumenstrom des zu ionisierenden Gases, gegebenenfalls der Trägergasvolumenstrom und der Abstand zwischen dem Ausgang des Relaxationsraumes und der Substratoberfläche so gewählt, dass die Halbwertsbreite der abgeschiedenen Schichtverteilung ± 10 mm zur Mittelachse beträgt.

Eine besonders gute Abdeckung der zu beschichtenden Substratoberfläche mit einer plasmapolymeren Schicht, insbesondere einer Korrosionsschutzschicht, kann dementsprechend erreicht werden durch überlappendes Abscheiden von Beschichtungsspuren. Wird eine Halbwertsbreite einer Beschichtungsspur von ± 10 mm gewählt, dann beträgt vorzugsweise der Versatz zwischen zwei Spuren 3 bis 5 mm.

Die Beschichtungsvorrichtung kann, beispielsweise durch einen Roboterarm, relativ zur zu beschichtenden Oberfläche mehrfach über die Oberfläche verfahren werden und dabei mehrere plasmapolymere Schichten und insbesondere Korrosionsschutzschichten auf der zu beschichtenden Oberfläche übereinander auftragen. Vorzugsweise besitzt die erfindungsgemäße Beschichtungsvorrichtung eine Steuerung zum Verfahren der Vorrichtung relativ zur Substratoberfläche dergestalt, dass zumindest zwei plasmapolymere Schichten auf der Oberfläche abgeschieden werden, vorzugsweise zumindest drei Schichten und besonders bevorzugt vier bis sechs Schichten. Auf diese Weise können eventuell noch verbliebene Fehlstellen bei Auftragen einer einzelnen plasmapolymeren Schicht und insbesondere Korrosionsschutzschicht - beispielsweise hervorgerufen durch Staubverunreinigungen während des Auftragens der plasmapolymeren Schicht - in nachfolgenden Beschichtungsvorgängen abgedeckt und daher in ihrer Schädlichkeit begrenzt oder vollständig ausgemerzt werden.

Dabei können auch Schichten mit unterschiedlichen Eigenschaften kombiniert werden, indem zwischen den einzelnen Prozessschritten die Parameter der Beschichtung variiert werden.

Vorzugsweise umfasst die erfindungsgemäße Beschichtungsvorrichtung auch Reinigungsschritte zum Reinigen der zu beschichtenden Oberfläche vor dem Auftragen einer plasmapolymeren Schicht, insbesondere einer Korrosionsschutzschicht. Zum Reinigen besonders geeignet sind mechanische Vorbehandlungsverfahren, wie Fräsen, Schleifen, Bürsten und Zuführungen zum Freiblasen oder Absaugen von Verunreinigungen von der zu behandelnden Oberfläche.

Besonders gute Reinigungsergebnisse können erzielt werden durch eine Plasmabehandlung der zu beschichtenden Oberfläche mit einem Atmosphärendruck-Plasma unter Verwendung von Sauerstoff oder einem sauerstoffhaltigen Gas wie beispielsweise Druckluft als zu ionisierendem Gas. Durch eine solche Plasmavorbehandlung einer zu beschichtenden Oberfläche, inbesondere einer Metalloberfläche, können anschließend besonders gut haftende und besonders korrosionsschützende plasmapolymere Beschichtungen aufgebracht werden. Beispielsweise kann durch eine Plasmabehandlung eine natürliche Oxidschicht auf unterschiedlichen Metallen und Metalllegierungen erzeugt oder vergrößert werden. So können beispielsweise auf der Aluminium-Legierung EN-AW 6061 Oxidschichten von ursprünglich 4 nm Dicke auf 6 nm und mehr gebracht werden. Die Plasmavorbehandlung kann beispielsweise dadurch geschehen, dass bei einer erfindungsgemäßen Beschichtungsvorrichtung kein Precursor dem relaxierenden Plasma zugeführt wird und das relaxierende Plasma über die zu beschichtende Oberfläche geführt wird.

Ferner hat es sich als vorteilhaft herausgestellt, eine abgeschiedene Korrosionsschutzschicht oder andere plasmapolymere Schicht mit einem Plasma zu behandeln, um die Oberflächeneigenschaften der abgeschiedenen plasmapolymeren Schicht weiter anzupassen. Die plasmapolymere Korrosionsschutzschicht besitzt üblicherweise eine hydrophobe Oberfläche. Diese ist gut geeignet für Anwendungen, bei denen keine weitere Oberflächenbehandlung wie beispielsweise Beschichtung oder Lackierung erfolgen soll, da hydrophobe Oberflächen zusätzlich zur Sperrwirkung der plasmapolymeren Korrosionsschutzschicht gegenüber korrosiven Medien auch zu einer verringerten Verweildauer von korrosiven tropfenförmigen Medien und Flüssigkeiten auf entsprechend beschichteten Oberflächen führen. Soll eine mit einer Korrosionsschutzschicht oder anderen plasmapolymeren Schicht versehene Oberfläche jedoch weiter bearbeitet und beispielsweise beschichtet, lackiert oder verklebt werden, so kann die mit der erfindungsgemäßen Beschichtungsvorrichtung beschichtete Oberfläche durch einen zusätzlichen Plasmaaktivierungsschritt behandelt werden. Durch Verwendung von Druckluft oder Sauerstoff als Ionisationsgas kommt es zur Bildung von hydrophilen funktionellen Gruppen auf der vom beschichteten Substrat abgewandten Oberfläche der plasmapolymeren Schicht, und insbesondere zur Bildung von - COOH, -OH etc. Gruppen, die zu einer guten Benetzbarkeit der Oberfläche auch bei Wasserlacken führen. Zum Plasmaaktivieren der beschichteten Oberfläche können, wie schon zum Reinigen der noch unbeschichteten Oberfläche, Sauerstoff oder ein sauerstoffhaltiges Gas und insbesondere Druckluft als zu ionisierendem Gas verwendet werden, wobei die übrigen Parameter der Plasmabeaufschlagung und insbesondere die Wahl des Abstandes zwischen dem Austritt des Relaxationsraumes und der zu beschichtenden Oberfläche sowie des Volumenstromes des Ionisationsgases vorzugsweise die gleichen sind wie zum Erzeugen der plasmapolymeren Schicht und insbesondere Korrosionsschutzschicht, wobei natürlich die Precursor-Zugabe unterbleibt. Zur Plasmareinigung der zu beschichtenden Oberfläche und zur Plasmaaktivierung der beschichteten Oberfläche kann daher die erfindungsgemäße Vorrichtung mehrfach verwendet werden. Alternativ dazu kann die erfindungsgemäße Beschichtungsvorrichtung auch neben einer Düse zum Erzeugen des relaxierenden, precursor-haltigen Plasmas auch eine oder mehrere weitere Düsen zum Erzeugen eines Plasmas zum Reinigen und/oder Nachbehandeln der jeweiligen Oberfläche umfassen.

Die Erfindung wird nachfolgend anhand der Figuren und der Ausführungsbeispiele sowie von Vergleichsbeispielen näher beschrieben, ohne dass dadurch der Schutzbereich der Patentansprüche eingeschränkt werden soll.
- Fig. 1: zeigt einen schematischen Querschnitt einer erfindungsgemäßen Vorrichtung zum Herstellen einer Korrosionsschutzschicht auf einer Substratoberfläche durch Plasmapolymerisation, und
- Fig. 2: zeigt plasmapolymerbeschichtete Aluminium-Oberflächen.

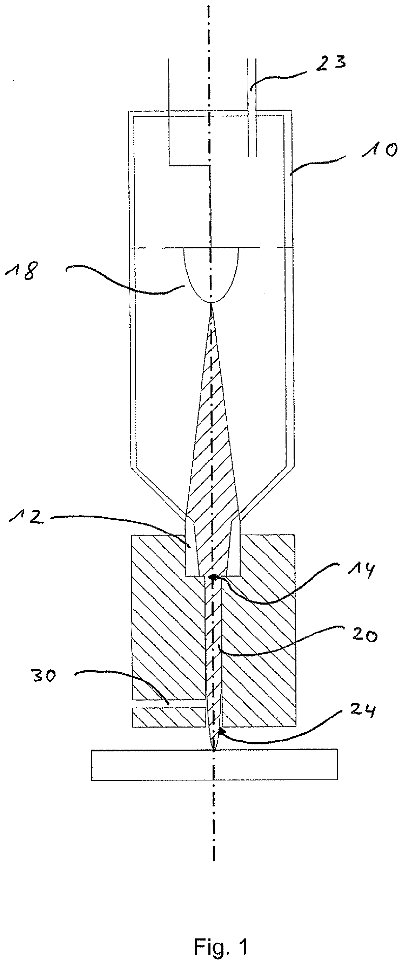

Die in Fig. 1 gezeigte Vorrichtung besitzt ein düsenförmiges Gehäuse 10 eines Plasmaerzeugungsraumes, das einen langgestreckten, am unteren Ende konisch verjüngten Düsenkanal 12 mit einem Austritt 14 aus dem Gehäuse 10 bildet. In Gasströmungsrichtung stromabwärts vom Gehäuse 10 des Plasmaerzeugungsraumes ist ein Relaxationsraum 20 mit einer Precursoreinspeisung 30 angeordnet, wobei der Abstand zwischen dem Austritt 14 des Gehäuses 10 des Plasmaerzeugungsraumes zur Precursoreinspeisung 30 1 bis 25 mm, bevorzugt 1 bis 7mm beträgt. Die Precursoreinspeisung 30 ist ausgebildet als rohrförmige Durchbrechung der Wand des Relaxationsraumes 20. Die Precursoreinspeisung 30 ist an ihrer Mündung zum Innenraum des Relaxationsraumes 20 von im Wesentlichen kreisförmigem Querschnitt mit einem Durchmesser von 1 bis 4 mm und vorzugsweise von 3 mm. Der Relaxationsraum 20 ist rotationssymmetrisch zu seiner Mittelachse, der Abstand zwischen der Mündung der Precursoreinspeisung 30 und der Mittelachse des Relaxationsraumes 20 beträgt 0,25 bis 15 mm und besonders bevorzugt 1 bis 3 mm. Die Beschichtungsvorrichtung umfasst zusätzlich eine Ionisationsgaszufuhr 23 zum Zuführen eines im Plasmaerzeugungsraum zu ionisierenden Gases. Die Ionisationsgaszufuhr kann einen Volumenstrom des zu ionisierenden Gases von 15 bis 50 l/min einstellen. Besonders bevorzugt beträgt der Volumenstrom des zu ionisierenden Gases 29 l/min ± 5 l/min.

Im Düsenkanal 12 ist eine Elektrode 18 angeordnet. Das Gehäuse 10 des Plasmaerzeugungsraumes ist geerdet und dient als Gegenelektrode, so dass eine elektrische Entladung zwischen der Elektrode 18 und dem Gehäuse 10 erzeugt werden kann. Die Elektrode 18 ist koaxial in den Düsenkanal 12 montiert und mit einem Hochspannungsgenerator (nicht dargestellt) zum Erzeugen einer Hochspannung von einigen Kilovolt und beispielsweise einer Frequenz in der Größenordnung von 20 Kilohertz verbunden. Beim Anlegen der Spannung wird eine Bogenentladung zwischen der Elektrode 18 und dem Gehäuse 10 gezündet.

Zur Erzeugung des precursorhaltigen Plasmas kann im Prinzip jede beliebige Plasmadüse mit einem Relaxationsraum und einer Ionisationsgaszufuhr wie vorstehend beschrieben verwendet werden. Insbesondere können die in der EP 1230414 A1 und B1 beschriebenen Plasmadüsen unter entsprechender Anpassung der Mündung der Precursorzuführung und der Ionisationsgaszufuhr verwendet werden. Für eine detaillierte Beschreibung bevorzugter Plasmadüsen wird daher auf die EP 1230414 A1 verwiesen

Der Relaxationsraum 20 besitzt vorzugsweise eine Wand aus Aluminium. Durch die Precursoreinspeisung 30 wird ein Trägergas und besonders bevorzugt Druckluft, Sauerstoff oder Stickstoff in den Innenraum des Relaxationsraumes 20 zusammen mit dem Precursor eingeleitet. Der Volumenstrom des Trägergases wird durch eine Trägergaszufuhr (nicht dargestellt) auf 0,1 bis 20 l/min und bevorzugt 1 bis 4 l/min eingestellt. Das Precursormaterial ist vorzugsweise siliziumhaltig und oder kohlenstoffhaltig und umfasst bevorzugt silizium-organische Verbindung oder besteht aus diesen. Besonders bevorzugt wird HMDSO oder TEOS als siliziumhaltiges Precursormaterial verwendet.

Das Precursormaterial wird im Relaxationsraum 20 teilfragmentiert und teilweise polymerisiert. Das aus dem Gehäuse 10 des Plasmaerzeugungsraumes austretende Plasma wird im Relaxationsraum 20 mit dem eingespeisten Precursor durchmischt und tritt aus einem Austritt 24 des Relaxationsraumes aus. Vom Austritt 24 des Relaxationsraumes 20 ist ein Substrat mit einer zu beschichtenden Oberfläche etwa 0,5 bis 30 mm und besonders bevorzugt 3 bis 10 mm entfernt angeordnet. Das precursorhaltige Plasma trifft auf die Substratoberfläche auf, wobei der teilfragmentiert Precursor zu einer Korrosionsschutzschicht polymerisiert.

### Ausführungsbeispiel 1

Das Beispiel beschreibt, wie die beschriebene Vorrichtung und das Verfahren zum Korrosionsschutz von Bauteilen, bestehend aus der Aluminiumlegierung EN AW 6061, verwendet wird. Die Probe wird zur Oberflächenvorbereitung trocken gefräst.

Zunächst erfolgt eine Plasmavorbehandlung zur Aktivierung und Reinigung. Dazu wird die beschriebene Vorrichtung ohne Verwendung eines Precursors betrieben. Als Ionisationsgas wird Sauerstoff bei einer Flussrate von 29l/min verwendet. Der Abstand zwischen dem Austritt des relaxierenden Plasmastrahls aus der Vorrichtung und der Probenoberfläche beträgt 6mm, die Verfahrgeschwindigkeit 20m/min. Die Behandlung wird zweimal wiederholt.

Anschließend erfolgt die Schichtabscheidung. Bei gleichen Prozessparametern, wie eben ausgeführt, wird nun zusätzlich Hexamethyldisiloxan (HMDSO) als Precursor verwendet. Dabei werden 0.4g/min HMDSO bei 80°C mit einem Trägergasflusses von 2l/min Stickstoff in den dargestellten Relaxationsbereich 20 eingespeist. Das Relaxationsvolumen weist dabei eine Länge von 4mm bei einem Durchmesser von 3mm auf. Die Einspeisung des Precursor erfolgt von einer Seite (wie dargestellt) oder symmetrisch von 2 Seiten. Der Beschichtungsprozess wird 3 mal wiederholt. Anschließend wird die beschichtete Probe 30min lang bei 80° in einem Ofen getempert. Die Schutzwirkung der Beschichtung wurde durch Auslagerung der Proben in einem neutralen Salzsprühtest gemäß DIN 50021SS geprüft. Nach 400h Auslagerung war keine Korrosion beobachtbar. Eine unbeschichtet Referenzprobe wies dagegen nach 50 h erste Korrosionsdefekte auf.

### Ausführungsbeispiel 2

Das oben beschriebene Vorgehen kann auch zur Beschichtung von Aluminium Al99.5 eingesetzt werden. Die Ausführung erfolgte wie in Ausführungsbeispiel 1, die Vorbehandlung erfolgte jedoch durch Reinigungen mit Iso-Propanol und die Substrattemperatur während der Beschichtung betrug 45°C. Es erfolgte keine anschließende Temperung der Beschichtung. Die Schutzwirkung der Beschichtung wurde durch Auslagerung der Proben in einem neutralen Salzsprühtest in gemäß DIN 50021SS geprüft. Nach 1000h Auslagerung war keine Korrosion beobachtbar. Eine unbeschichtet Referenzprobe wies dagegen nach 200 h erste Korrosionsdefekte auf.

### Vergleichsbeispiel:

Auf einem gefrästen Al2024-Substrat wurden mit folgenden Prozessparametern bei Atmosphärendruck plasmapolymere Schichten abgeschieden:

| | |
|---|---|
| Precursor: | HMDSO, 0,4 g/min |
| Precursor-Trägergas: | N2, 2 l/min |
| Ionisationsgas: | O2, 29 l/min |
| Verfahrgeschwindigkeit. | 20 m/min |
| Abstand Plasmaaustritt-Substrat: | 6 mm |

Die Beschichtung wurde einmal mit einer erfindungsgemäßen Beschichtungsvorrichtung (zylindrisches Relaxationsvolumen von 7 mm Länge, 3 mm Durchmesser) und einmal bei ansonsten gleichen Parametern ohne einen Relaxationsraum durchgeführt. Die so erhaltenen Proben wurden zusammen mit einer unbeschichteten Referenzprobe 168 Stunden lang einem Wechseltauchtest nach DIN EN 3212 behandelt.

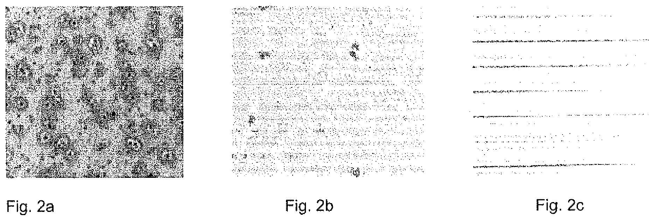

Figur 2a zeigt, dass das unbeschichtete Aluminiumsubstrat stark korrodiert ist. Figur 2b zeigt das beschichtete Aluminiumsubstrat, das ohne Relaxationsraum beschichtet wurde. Einige Korrosionsdefekte sind erkennbar, diese gehen auf Schichtdefekte der plasmapolymeren Schicht zurück. Figur 2c zeigt das erfindungsgemäß beschichtete Aluminiumsubstrat. Dieses ist frei von Korrosionsdefekten.

## Patentansprüche

1. Beschichtungsvorrichtung zur Nichtvakuum - Plasmapolymerisation, umfassend
- einen Plasmaerzeugungsraum mit
- einem Gehäuse (10) zur Aufnahme eines darin erzeugten Plasmas,
- einem vom Gehäuse (10) gebildeten Düsenkanal (12) mit einem Austritt (14) aus dem Gehäuse (10),
- wobei der Düsenkanal (12) vor Austritt (14) zwei konisch verjüngte Bereiche umfasst,
- einer im Düsenkanal (12) angeordneten Elektrode,
- einer Ionisationsgaszufuhr (23) zum Zuführen eines im Plasmaerzeugungsraum zu ionisierenden Gases mit einem Volumenstrom von 15 bis 50 l/min,
- einen durch den Austritt (14) vom Plasmaerzeugungsraum abgegrenzten Relaxationsraum (20), umfassend
- eine Precursoreinspeisung (30), die
- vom Austritt (14) des Gehäuses (10) des Plasmaerzeugungsraumes 1 bis 25 mm, bevorzugt 1 bis 7 mm, beabstandet ist.

2. Beschichtungsvorrichtung nach Anspruch 1, **dadurch gekennzeichnet, dass** die Precursoreinspeisung (30) 0,25 bis 15 mm von einer Mittelachse des Relaxationsraumes entfernt angeordnet ist.

3. Beschichtungsvorrichtung nach einem der vorherigen Ansprüche, ferner umfassend eine Trägergaszufuhr zum Zugeben des Precursors in einen Trägergasstrom von 0,1 bis 20 l/min

4. Beschichtungsvorrichtung nach einem der vorherigen Ansprüche, ferner umfassend Mittel zum Einstellen eines Gasdruckes über einem zu beschichtenden Substrat von zumindest 100 mbar.

5. Beschichtungsvorrichtung nach einem der vorherigen Ansprüche, ferner umfassend einen Abstandhalter zum Halten eines zu beschichtenden Substrates auf einen Abstand von 0,5 bis 30 mm vom Düsenkopf (= Austritt Relaxationsraum).

6. Beschichtungsvorrichtung nach einem der vorherigen Ansprüche, ferner umfassend eine Heizung zum Temperieren einer zu beschichtenden Substratoberfläche auf eine Temperatur von 0°C bis 300°C.

7. Beschichtungsvorrichtung nach einem der vorherigen Ansprüche, ferner umfassend eine Steuerung zum Führen des Düsenkopfes relativ zur Substratoberfläche dergestalt, dass mehrere einander teilweise überlappende Beschichtungen auf der Substratoberfläche gebildet werden.

8. Beschichtungsverfahren zum Beschichten einer Substratoberfläche, umfassend den Schritt des Beaufschlagens der Substratoberfläche mit einem Plasma bei einem Umgebungs-Gasdruck von zumindest 100 mbar, in das in einem Relaxationsraum (20) ein Precursor im Abstand von 1 bis 25 mm, bevorzugt 1 bis 7 mm entfernt vom Austritt (14) eines Gehäuses (10) eines Plasmaerzeugungsraums einer Beschichtungsvorrichtung nach einem der Ansprüche 1 bis 7 bei einem Ionisationsgasstrom von 15 bis 50 l/min eingespeist wird, wobei der Relaxationsraum (20) vom Plasmaerzeugungsraum durch den Austritt (14) abgegrenzt wird.

9. Beschichtungsverfahren nach Anspruch 8, ferner umfassend den Schritt des Heizens der zu beschichtenden Substratoberfläche auf eine Temperatur von 0°C bis 300°C vor, während oder nach Beaufschlagen der Substratoberfläche mit dem Plasma.

10. Beschichtungsverfahren nach einem der Ansprüche 8 bis 9, **dadurch gekennzeichnet, dass** das Plasma in mindestens zwei einander überlappenden Spuren über die Substratoberfläche geführt wird.

11. Beschichtungsverfahren nach einem der Ansprüche 8 bis 10, **dadurch gekennzeichnet, dass** die mit dem Plasma beaufschlagte Substratoberfläche vorher einer Plasmareinigung mittels Druckluft oder Sauerstoff unterzogen wird.

12. Beschichtungsverfahren nach einem der Ansprüche 8 bis 11, **dadurch gekennzeichnet, dass** die beschichtete Oberfläche durch einen nachgeschalteten Plasmaprozess durch die Erzeugung hydrophiler Gruppen an der Schichtoberfläche aktiviert wird.

## Claims

1. A coating device for non-vacuum plasmapolymerisation, comprising
- a plasma generating chamber comprising
- a housing (10) for accommodating a plasma generated therein,
- a nozzle duct (12) formed by the housing (10) comprising an outlet (14) from the housing (10),
- wherein the nozzle duct (12) upstream of outlet (14) comprises two tapered areas,
- an electrode arranged in the nozzle duct (12),
- an ionisation gas supply (23) for supplying a gas to be ionised in the plasma generating chamber with a volume flow of between 15 and 50 l/min,
- a relaxation chamber (20) delimited from the plasma generating chamber by the outlet (14), comprising
- a precursor feed (30), which
- is between 1 and 25 mm, preferably between 1 and 7 mm spaced apart from the outlet (14) of the housing (10) of the plasma generating chamber,

2. The coating device according to claim 1, **characterised in that** the precursor feed (30) is arranged between 0.25 and 15 mm spaced apart from a centre axis of the relaxation chamber.

3. The coating device according to one of the preceding claims, further comprising a carrier gas supply for adding the precursor in a carrier gas flow of between 0.1 and 20 l/min.

4. The coating device according to one of the preceding claims, further comprising means for adjusting the gas pressure above a substrate to be coated of at least 100 mbar.

5. The coating device according to one of the preceding claims, further comprising a spacer for holding a substrate to be coated at a distance of between 0.5 and 30 mm from the nozzle head (= outlet relaxation chamber).

6. The coating device according to one of the preceding claims, further comprising a heater for temperature-controlling a substrate surface to be coated to a temperature of between 0°C and 300°C.

7. The coating device according to one of the preceding claims, further comprising a controller for guiding the nozzle head relative to the substrate surface in such a way that a plurality of coatings, which partially overlap one another, are formed on the substrate surface.

8. A coating method for coating a substrate surface, comprising the step of applying a plasma to the substrate surface at an ambient gas pressure of at least 100 mbar, in that a precursor is introduced in a relaxation chamber (20) at a distance of between 1 and 25 mm, preferably between 1 and 7 mm from the outlet (14) of a housing (10) of a plasma generating chamber of a coating device according to one of claims 1 to 7 with an ionisation gas flow of between 15 and 50 l/min, wherein the relaxation chamber (20) is delimited from the plasma generating chamber by means of the outlet (14).

9. The coating method according to claim 8, further comprising the step of heating the substrate surface to be coated to a temperature of between 0°C and 300°C prior to, during or after applying the plasma to the substrate surface.

10. The coating method according to one of claims 8 to 9, **characterised in that** the plasma is guided across the substrate surface in at last two tracks, which overlap one another.

11. The coating method according to one of claims 8 to 10, **characterised in that** the substrate surface, to which the plasma is applied, is first subjected to a plasma cleaning by means of compressed air or oxygen.

12. The coating method according to one of claims 8 to 11, **characterised in that** the coated surface is activated by means of a plasma process connected downstream by generating hydrophilic groups on the layer surface

## Revendications

1. Dispositif de revêtement pour la polymérisation sans vide - au plasma comprenant
- un espace de génération de plasma avec
- un boîtier (10) pour la réception d'un plasma généré dedans,
- un canal de buse (12) formé par le boîtier (10) avec une sortie (14) du boîtier (10),
- dans lequel le canal de buse (12) comporte, avant la sortie (14) ; deux zones rétrécies en cône,
- une électrode disposée dans le canal de buse (12),
- une alimentation de gaz d'ionisation (23) pour l'alimentation d'un gaz à ioniser dans l'espace de génération de plasma avec un débit volumique de 15 à 50 l/min,
- un espace de relaxation (20) délimité par la sortie (14) de l'espace de génération de plasma, comprenant
- une injection de précurseur (30) qui
- est espacée de la sortie (14) du boîtier (10) de l'espace de génération de plasma de 1 à 25 mm, de préférence de 1 à 7 mm.

2. Dispositif de revêtement selon la revendication 1, **caractérisé en ce que** l'injection de précurseur (30) est disposée à distance de 0,25 à 15 mm d'un axe médian de l'espace de relaxation.

3. Dispositif de revêtement selon l'une des revendications précédentes, comprenant de plus une alimentation de gaz porteur pour l'ajout du précurseur dans un flux de gaz porteur de 0,1 à 20 l/min.

4. Dispositif de revêtement selon l'une des revendications précédentes, comprenant de plus des moyens pour le réglage d'une pression de gaz sur un substrat à revêtir d'au moins 100 mbars.

5. Dispositif de revêtement selon l'une des revendications précédentes, comprenant de plus un élément d'écartement pour le maintien d'un substrat à revêtir à une distance de 0,5 à 30 mm de la tête de buse (= sortie d'espace de relaxation).

6. Dispositif de revêtement selon l'une des revendications précédentes, comprenant de plus un chauffage pour la mise à température d'une surface de substrat à revêtir à une température de 0 °C à 300 °C.

7. Dispositif de revêtement selon l'une des revendications précédentes, comprenant de plus une commande pour le guidage de la tête de buse par rapport à la surface de substrat de telle manière que plusieurs revêtements se recouvrant partiellement soient formés sur la surface de substrat.

8. Procédé de revêtement pour le revêtement d'une surface de substrat, comprenant l'étape d'alimentation de la surface de substrat avec un plasma pour une pression de gaz environnante d'au moins 100 mbars, dans laquelle, dans un espace de relaxation (20), un précurseur est injecté à une distance de 1 à 25 mm, de préférence de 1 à 7 mm, de la sortie (14) d'un boîtier (10) d'un espace de génération de plasma d'un dispositif de revêtement selon l'une des revendications 1 à 7 pour un flux de gaz d'ionisation de 15 à 50 l/min, dans lequel l'espace de relaxation (20) est délimité de l'espace de génération de plasma par la sortie (14).

9. Procédé de revêtement selon la revendication 8, comprenant de plus l'étape de chauffage de la surface de substrat à revêtir à une température de 0 °C à 300 °C avant, pendant ou après l'alimentation de la surface de substrat par le plasma.

10. Procédé de revêtement selon l'une des revendications 8 à 9, **caractérisé en ce que** le plasma traverse la surface de substrat dans au moins deux voies se recouvrant.

11. Procédé de revêtement selon l'une des revendications 8 à 10, **caractérisé en ce que** la surface de substrat alimentée en plasma est soumise préalablement à un nettoyage de plasma par de l'air comprimé ou de l'oxygène.

12. Procédé de revêtement selon l'une des revendications 8 à 11, **caractérisé en ce que** la surface revêtue est activée par un processus de plasma en aval par la génération de groupes hydrophiles sur la surface de couche.
